**Europäisches Patentamt**

**European Patent Office**

**Office européen des brevets**

(19)

(11) Publication number : **0 394 582 B1**

# EUROPEAN PATENT SPECIFICATION

(12)

(45) Date of publication of patent specification :
**20.12.95 Bulletin 95/51**

(51) Int. Cl.⁶ : **G05B 13/04, H01L 41/00, H02N 2/00**

(21) Application number : **89310286.3**

(22) Date of filing : **09.10.89**

(54) **Magnetostrictive actuator using adaptive control.**

(30) Priority : **26.04.89 GB 8909483**

(43) Date of publication of application :
**31.10.90 Bulletin 90/44**

(45) Publication of the grant of the patent :
**20.12.95 Bulletin 95/51**

(84) Designated Contracting States :
**DE FR GB IT NL**

(56) References cited :
**WO-A-85/02445
US-A- 4 585 978
L. DUGARD et al.: "Commande adaptative méthodologie et applications", July 1988, pages 22-29, Hermes, Paris, FR
KONSTRUKTION, vol. 35, no. 4, 1983, pages 157-159, Springer-Verlag; M.J. VILENIUS: "Kombinations-regelungen verbessern die Eigenschaften elektrohydraulischer Stellungsregelkreise"
K.J.ASTROM & B. WITTENMARK:" Adaptive Control" January 1989 ,pages 379-395 , Addison-Wesley US
DATABASE WPI. Week 8114, Derwent Publications Ltd.,London GB. CLass X25 AN 81-D0692D, abstract. & SU-A-750176 (KUIB ENG CONS INST.)**

(73) Proprietor : **The Secretary of State for Defence in Her Britannic Majesty's Government of the United Kingdom of Great Britain and Northern Ireland
Whitehall
London SW1A 2HB (GB)**

(72) Inventor : **Greenough, Rodney David
45 Ferriby Road
Hessle North Humberside HU3 0HS (GB)**
Inventor : **Wilkinson, Anthony James
18 Mizzen Road
Hull (GB)**
Inventor : **Jenner, Gordon Alan
38 Ryde Street
Hull HU15 1QA (GB)**
Inventor : **Parvinmehr, Ahmed
10 Cornwood Way
Haxby York Y03 8GU (GB)**

(74) Representative : **Beckham, Robert William et al
Defence Research Agency
Intellectual Property Department
DRA Farnborough
Farnborough, Hants. GU14 6TD (GB)**

## Description

This invention relates to magnetostrictive actuators and in particular those operated in conjunction with adaptive control systems for control of their operation.

Actuators made from magnetostrictive materials are known to exhibit useful strains on applied loads but suffer from wide variations in response to changes in load. This, the presence of hysteresis in the strain versus magnetic field intensity curve known to be exhibited by these materials, renders the use of conventional adaptive control systems such as those having a linear feedback design wholly inadequate for the purpose.

It is an object of this invention to provide a magnetostrictive actuator whose construction and mode of operation makes full use of the properties of known magnetostrictive materials.

It is a further object of the invention to provide an actuator whose adaptive control system is able to accommodate changes in process response throughout the course of its normal operation. Therefore, the control strategy employed must be robust to variations in system gain as well as being able to adapt to changes in operating dynamics.

In WO-A-85/02445 there is described a magnetostrictive valve including a rod of magnetostrictive material enclosed within a cylindrical housing, an electromagnet which is incorporated in said housing and magnetically coupled to the rod and a spring which is arranged to exert an axial tension or compression sufficient to reduce hysteresis present in the magnetostrictive action. According to this document, a control device is provided to control the supply of current to the electromagnet in dependence of selected parameters and in accordance with a predetermined program. The current to the electromagnet induces a magnetic field in the magnetostrictive material of the rod, forcing a change in the rod's dimensions (particularly its length) and hence movement of a valve member whose position is controlled by the position of the end of the rod.

Such an arrangement does not however make efficient use of the magnetostrictive properties of the known materials, so that especially long rods or excessive currents are required for any given extension.

The present invention makes use of the fact that the materials in question generally exhibit enhanced magnetostrictive properties when in a state of high compression.

Accordingly, this invention consists of a magnetostrictive actuator for control of apparatus and comprising: a cylindrical housing having an open end and a closed end; a rod of magnetostrictive material retained within said housing, a fixed end of the rod abutting the closed end of the housing; an electromagnet incorporated in said housing and magnetically coupled to the rod; and a control system responsive to an externally-generated demand signal for generating a control signal within the electromagnet, the control signal and electromagnet signal inducing a corresponding magnetic field within the rod; characterised by a loading head secured to the open end of the cylindrical housing and accommodating the other, free end of the rod within an axial bore extending the full length thereof a closure member engaged within the axial bore and defining a cavity between the free end of the rod and the closure member; a spring located within the cavity and compressed between the free end of the rod and the closure member for applying an adjustable axial compressive stress to the free end of the rod; and an actuating member extending through the closure member and in contact with the rod, the axial position of the actuating member, relative to the loading head, being responsive to the length of the rod, the actuating arm being linkable to the apparatus to be controlled; the control means comprising: an estimator for providing model parameters of the response of the control system to an external disturbance; a control designer, responsive to the estimator, for comparing the model provided by the estimator with the required parameters and for generating feedback control signals as a result of such comparison; two switched filters for applying to the control current positive and negative feedback signals, respectively; and a variable structure controller for controlling switching between the two filters in response to the demand signal.

A control system as just referred to (employing self-tuning techniques in combination with variable structure techniques) is able to provide accurately tuned cancellation of any observable disturbances which affect the process to be controlled. The variable structure controller of this invention is made to operate in a discrete mode in contrast to the better known continuous mode. Unlike linear feedback controller designs the variable structure controller is able to deliver a stable closed loop system response even under conditions of extreme process modelling error.

A useful feature of such a system is a fast convergence rate of process model estimates due to the nature of the controlled process input. This is exceptionally useful in circumstances where the process model changes from its original value. This type of control strategy is most suitable for real-time process control applications since a Variable Structure Control design requires very little computation time.

The feedback control signals which are applied to the process are hazardous in real-time control systems and can rapidly cause damage to expensive and delicate actuators. However, magnetostrictive actuators are immune to this type of vigorous control signal, being solid state and therefore robust.

Hence, this type of actuator is well suited to be controlled by a such an adaptive control system.

A discrete sliding criterion, necessary for the operation of the variable structure controller is formulated using a discrete difference operator which, in turn, is derived from the "Delta operator". These operators are described in greater detail hereinafter.

Some embodiments of the invention will now be described, by way of example only, with reference to the drawings of which:

Fig 1 is a block diagram of an adaptive control system as employed in the invention; and

Fig 2 is a block diagram showing the control system of an actuator-operated valve constructed in accordance with the invention.

In a variable structure control system, the feedback structure of the system is switched, almost instantaneously, back and forth from one type of feedback controller (positive or negative) to the other.

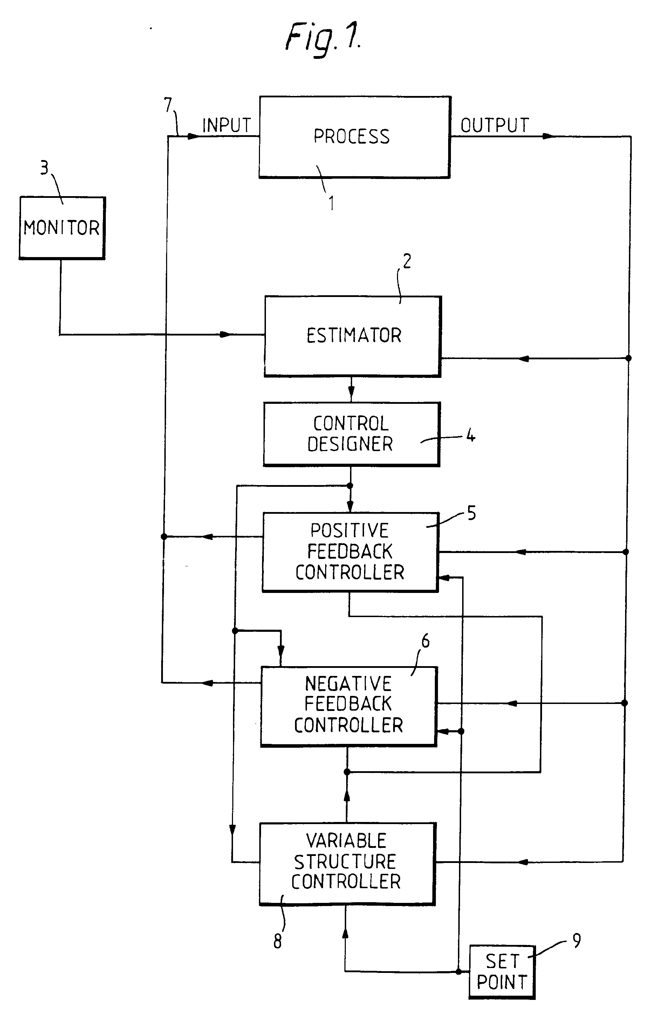

Fig 1 shows a process (or plant) 1 which is to be adaptively controlled. An estimator 2 receives information relating to the status or operating condition of the process. Such information can relate to any external disturbances, detected by a monitor 3, to which the process 1 is susceptible and to the output status of the process 1 itself. The estimator 2 thus generates process model parameters that best describe the response of the controlled process - in other words it generates a simulation of the process according to the information it receives.

The process model parameters output from the estimator are input to a control designer 4 which compares these parameters with the required parameters for the process. The required parameters are derived from an algorithm representing the feedback characteristics which is stored in the control designer. The control designer then calculates positive and negative feedback signals from the most recently derived process model parameters.

Said feedback signals are applied to a positive feedback controller 5 and to a negative feedback controller 6. These controllers act as filters and generate a process control input on line 7. Switching between the feedback controllers 5 and 6 is effected by the output from a variable structure controller 8 which receives information from the output of the control designer 4, the output of the process 1 and a set point signal. The set point signal is the desired process output and is derived, for example, from a manually operated potentiometer 9. The set point signal is also applied to each feedback controller 5 and 6 along with the process output.

The embodiment of Fig 1 having two feedback controllers is a simple, second order control system. Higher order systems can be provided by the addition of further switched feedback controllers.

Conveniently, the Delta operator, proposed by Goodwin in "Some Observations on Robust Estimation and Control" - IFAC Identification and System Parameter Estimation 1985 pp 851-859, is used to derive the algorithms for the estimator, control designer and variable structure controller.

In this example a forward difference operator ie the "delta" operator "D" can be denoted as:

$$D = \frac{Z - 1}{\Delta} \quad (1)$$

where $Z$ represents the $Z$ transform and can be thought of as the standard forward shift operator in discrete system analysis, and $\Delta$ is the sampling period.

A prediction, therefore, of one sample into the future is required but this can be eliminated if the difference operator is delayed by one sample.

$$\text{ie } Z^{-1}D = Z^{-1}\frac{(Z - 1)}{\Delta} \quad (2)$$

Thus as $\Delta \to 0$ then the $Z^{-1}D$ operator provides a better approximation of the continuous derivative. For discrete systems analysis directly comparable with Z-transforms the difference operator (2) can be normalised ($\Delta = 1$) giving a discrete difference operator of the form:-

$$Z^{-1}D = Z^{-1}(Z - 1) \quad (3)$$

This discrete operator provides an elegant way of representing discrete processes in difference form with poles and zeros in the unit disc. In the analogy that follows the discrete difference operator is used to formulate a discrete sliding criterion.

If $\sigma(t)$ represents the sliding manifold (or switching signal; generated by the variable structure controller), in the phase plane, then the existence of the sliding motion is guaranteed by the following inequality:-

$$\sigma(t)\frac{d\sigma(t)}{dt} < 0 \quad (4)$$

where

$$\sigma(t) = x_2 + Cx_1 \quad (5)$$

where

$\quad$ C = sliding manifold slope.

$\quad x_1$ = process output or error

$\quad x_2$ = rate of change of $x_1$

the $Z^{-1}D$ operator can be used to provide a discrete analogy of the sliding criterion. ie $\sigma(t)\frac{d\sigma(t)}{dt}$ can be written as

$$Z^{-1}(\sigma(t).D\sigma(t))$$

Thus;

$$\sigma(t) \simeq Z^{-1}((x_1(t + 1) - x_1(t)) + Cx_1(t))$$
$$\simeq (D + C)x_1(t - 1) \quad (7)$$

and

$$\frac{d\sigma(t)}{dt} \simeq Z^{-1}(\sigma(t + 1) - \sigma(t))$$
$$\simeq (Z^{-1}(D + C) - Z^{-2}(D + C))x_1(t)$$

Therefore the sliding criterion (4) can be expressed as:-

$$(Z^{-1}(D + C) - Z^{-2}(D + C))x_1(t)\sigma(t - 1) < 0 \quad (8)$$
$$\therefore Z^{-2}(Z(D + C) - (D + C))x_1(t)\sigma(t - 1) < 0$$
$$\therefore ((D + 1)(D + C) - (D + C)x_1(t - 2)\sigma(t - 1) < 0$$

This reduces to:-

$$(D^2 + CD)x_1(t - 2)\sigma(t - 1)<0 \quad (9)$$

Inequality (9) is the basic necessary sliding criterion in difference form but it is not sufficient for the existence of a quasi-sliding motion. For sufficiency the convergence of the discrete states must be guaranteed in the sliding mode. To ensure sufficiency the following inequality may be stated as

$$Z^{-1}D \, |\sigma(t)| <0$$

The control strategy and hence the discrete variable structure algorithm described above is particularly useful for the control of processes incorporating magnetostrictive devices.

Recent work in the field of ferromagnetic materials has resulted in the development of so called "giant" magnetostrictive materials. There are at present two compositions of giant magnetostrictive materials using terbium known to the applicant, namely:

i. $Tb_{0.3}Dy_{0.7}Fe_{1.9- 1.95}$

ii. $Tb_{0.27}Dy_{0.73}Fe_{1.9- 1.95}$

where Tb = terbium, Dy = dysprosium and Fe = iron and numerals refer to atomic ratios.

Both compositions are capable of developing linear strains of between 1000 to 2000 ppm dependent upon the level of prestress applied to the material and the intensity of the magnetic field to which the material is exposed. The efficiency of these two known compositions in converting magnetic energy supplied by an external magnetic field into strain energy, ie displacement, can be as much as 50% or even greater (the 0.27 terbium composition has a slightly greater efficiency than the 0.3 composition) and a rod of giant magnetostrictive material can operate under external uniaxial pressure of as much as 100 MPa, although the diameter of the rod will, of course, determine its maximum load bearing capability.

Whilst the properties of magnetostrictive materials, and more particularly giant magnetostrictive materials comprised of terbium, have been explored and determined as described in the preceding paragraph, they have yet to find many useful applications. Reasons for this are the non-linear behaviour of and the presence of hysteresis in the strain versus magnetic field intensity curves. Hysteresis depends upon loading and variations in the material characteristics. However, the non-linear and hysteretic behaviour can be accommodated quite satisfactorily by the adaptive controller as described above. The estimator is able to follow any changes in slope of the characteristic curve and the variable structure controller will account for any hysteresis.

A magnetostrictive actuator controlled by an adaptive controller in accordance with the invention will now be described.

A magnetostrictive actuator comprises a hollow cylindrical housing within which is located a tubular magnetising coil and, co-axial with the coil, a rod of magnetostrictive material. The length of the rod is greater than that of the housing and one end of the rod therefore extends through and beyond an aperture provided in an end face of the housing. The opposite end face of the housing is closed and the other end of the rod abuts against it.

A loading head is secured to the end face of the housing and accommodates the free end of the rod in a longitudinal bore extending the full length thereof. Within the longitudinal bore there are housed a spring, an actuating member and a screw threaded closure member. The screw threaded closure member is screw threadedly received in the outer end of the through bore in the loading head. This end of the through bore is tapped in order to accommodate the closure member. The spring and the actuating member are enclosed within the through bore in the loading head between the end of the magnetostrictive rod and the closure member and, by screwing the closure member further in or out of the through bore the tension in the spring can be varied to adjust the prestressing applied to the rod. This facility to adjust the level of prestressing allows the actuator to be used in different operating conditions. The level of prestressing will vary in accordance with the degree of compression in the spring and therefore it is desirable to operate the actuator in the middle of the spring operating capacity. The spring is chosen to ensure that when the rod expands the change in the level of prestress is kept to about 1%. Prestressing is of particular benefit in cases where the rod is composed of grain-oriented materials. In addition, the spring is chosen to have a high rate constant in order to allow the actuator to operate at high frequencies.

One end of the actuating member abuts against that end of the magnetostrictive rod which protrudes beyond the end face of the housing, and the other end of said member extends through the bore of the closure member and beyond the outer end of the loading head. In use the actuating member is connected to an element which is to be displaced in accordance with a process control signal generated by the adaptive controller of Fig 1. Said signal is applied to the magnetising coil.

If it is a requirement for the magnetostrictive rod, once prestressed, to operate in the linear region of its strain curve then it must be biased.

A static magnetic bias can be applied to the rod by means of a permanent magnet mounted in the housing.

Alternatively, a current-carrying coil would serve equally well. It is necessary for the magnetic bias to form part of the same magnetic circuit as the rod. With the magnetic bias provided by a permanent magnet, the effective level of biasing can be altered by moving a piece of high permeability material across the magnet or by removing part of the magnet from the magnetic circuit, so permitting adjustments to be made in keeping with operating conditions. In the case of a dc magnetising coil the magnetic bias is varied by varying the applied current.

Whether the magnetic biasing is provided by a coil or by a permanent magnet, it is preferable for the rod to be enclosed in a magnetic circuit so that most of the magnetic flux produced by the magnetising coil and by the magnetic bias passes through the rod. To this end the housing comprises a high permeability material which provides a continuous low resistance magnetic flux return path. The flux return path provided by the housing must have a greater permeability to flux than either the permanent magnet or the rod, but the cross-sectional area of the flux return path must be such that the material used will neither saturate nor require excessive magnetic energy to establish the magnetic flux for the rod.

In use, when a control signal is applied to the coil a magnetic field is created and magnetic flux flows in the rod. This causes the length of the rod to change either by contracting or expanding about the bias point provided by the permanent magnet. Of course, as the length of the rod changes so too does the position of the end of the actuating member. Thus, the actuator can be used to actuate by displacement another device or mechanism.

A typical magnetostrictive rod of either of the aforementioned compositions is capable of developing strains of between 1000 to 2000 ppm dependent on the relevant optimum prestress applied to the material and can operate with an external load of approximately 100 Mpa of pressure. Typically, this translates into a change of length of approximately 0.12 mm for a rod of approximately 142 mm in length and this change in length will occur even under pressures as high as 100 MPa. In order to ensure adequate displacement of the device of mechanism to be actuated the output of the actuator can be amplified by means of a mechanical amplification system, such as levers or gears.

The adaptive control system of Fig 1 in combination with the magnetostrictive actuator as just described can be used for control of hydraulic valves.

Valves which are retracted by solenoids suffer from lack of control (ie the valve is either open or shut) and the greater the lower required to operate the valve, the more uncontrolled its movement. Control can be achieved by replacing the solenoid with an electric motor but this is at the expense of actuation speed.

By using a magnetostrictive actuator controlled by an adaptive control system in accordance with the invention to operate a valve, both high speed and controlled actuation can be obtained. The valve could then provide prescribed flow rates on demand and, unlike motor driven valves, it would be fail-safe.

In one example of this, an actuating member of a magnetostrictive actuator of the type described above is connected to a 5 port - 2 position reversing valve unit, via a mechanical displacement amplifying lever system. The valve unit is of conventional design and therefore it is not considered necessary to describe it in detail herein, save to say that it comprises a spool which is axially displaceable within the valve body against a return spring provided at each end thereof to control the flow of a liquid between inlet/outlet ports.

Means are provided for obtaining information regarding the operating conditions of the valve. This information includes the spool position, the differential pressure across the valve and/or user demand (ie the set point input). This information is used by the adaptive control system of Fig 1 to generate appropriate input control signals to the actuator and thereby ensure that the actuating member is displaced in the right direction and by the required amount to achieve the required operating conditions.

Because the actual distance through which the end of the actuating member moves is small, of the order of 0.12 mm, the amplifying system is provided between the valve spool and the actuating member. This amplifies the movement in the approximate ratio 70:1, resulting in a maximum displacement of the spool by 8 mm. Response times of 1 mS or less can be achieved and a minimum force of approximately 8 kg is exerted on the spool return spring.

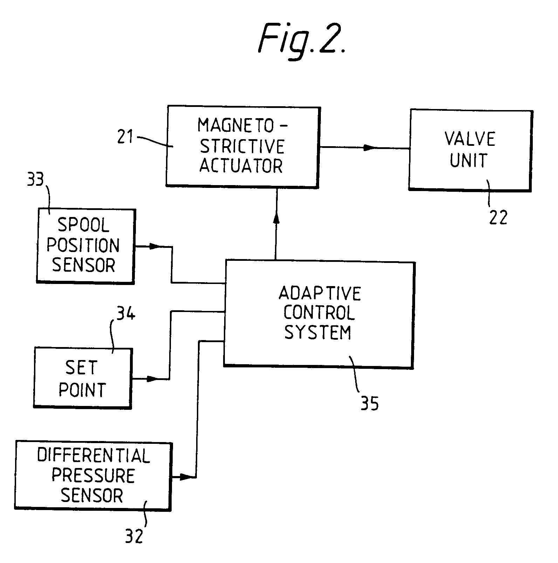

Referring now to Fig 2, signals from a differential pressure sensor 32, a spool position sensor 33 and a set-point transducer 34 are input to an adaptive control system 35 of the type described. The control system 35 thus generates an input control signal for the magnetising coil of the magnetostrictive actuator 21 to obtain a given displacement of the actuating member 20 and thence the valve spool incorporated within the valve unit 22.

A further example of the use to which the adaptive control system of Fig 1 and a magnetostrictive actuator may be put is with anti-vibration tables. A typical table comprises a horizontal member which forms the table top and which is supported at each corner by a guide leg mounted in linear bearings. Located centrally and underneath the table is a magnetostrictive actuator. The actuator comprises a housing containing a magnetostrictive rod and a magnetising coil. The housing sits on the floor and the rod supports the central portion of the table. More than one actuator may be used if the working loads on the anti-vibration table are such that one would be insufficient to cope.

Vibration sensors are provided in the guide legs of the table or the floor and the output of each of these sensors is input to an adaptive control system of a type in accordance with the invention The control system generates a control signal which, when applied to the magnetising coil of the magnetostrictive actuator, causes the rod to move by an equal, but opposite amount relative to the floor. In other words, if, for example, the floor vibrates at an amplitude of 0.1 mm and a frequency of 10 Hz, the magnetostrictive rod will vibrate up and down with the same frequency and amplitude, but in anti-phase with the incoming signal with the result that the table top is stationary.

As will be apparent, the table top is able to move up and down relative to the floor (the guide legs are slideably supported in the linear bearing) but it actually maintains a constant position in space and is therefore stationary - any movement of the floor is compensated for by the actuator device supporting the table top.

The anti-vibration techniques described herein can also be applied to the problems of vibration control in towed sonar arrays. It has been found, however, that the working loads which are generated in a typical tow line are such that a single magnetostrictive actuator is inadequate. The solution to this problem is to use a plurality of actuators aligned side by side and operate them in parallel from one adaptive control system.

## Claims

1. A magnetostrictive actuator for control of apparatus and comprising: a cylindrical housing having an open end and a closed end; a rod of magnetostrictive material retained within said housing, a fixed end of the rod abutting the closed end of the housing; an electromagnet incorporated in said housing and magnetically coupled to the rod; and a control system responsive to an externally-generated demand signal for generating a control signal for the electromagnet, the control signal and electromagnet signal inducing a corresponding magnetic field within the rod; characterised by a loading head secured to the open end of the cylindrical housing and accommodating the other, free end of the rod within an axial bore extending the full length thereof;
a closure member engaged within the axial bore and defining a cavity between the free end of the rod and the closure member;
a spring located within the cavity and compressed between the end of the rod and the closure member for applying an adjustable axial compressive stress to the free end of the rod; and
an actuating member extending through the closure member and in contact with the rod, the axial position of the actuating ann, relative to the loading head, being responsive to the length of the rod, the actuating member being linkable to the apparatus to be controlled;
the control means comprising:
an estimator (2) for providing model parameters of the response of the control system to an external disturbance;
a control designer (4), responsive to the estimator, for comparing the model provided by the estimator with the required parameters and for generating feedback control signals as a result of such comparison;
two switched filters (5, 6) for applying to the control current positive and negative feedback signals, respectively; and
a variable structure controller (8) for controlling switching between the two filters in response to the demand signal.

2. A magnetostrictive actuator according to Claim 1 in which the closure member is adjustably and threadedly engaged within the axial bore, wherein rotation of the plug causes axial movement of the plug, a change in length of the cavity and a change in the axial stress exerted by the spring on the free end of the rod.

3. A magnetostrictive actuator according to either preceding claim in which the housing incorporates a permanent bias magnet, which together with the rod comprises a magnetic flux circuit, the actuator further comprising means for varying magnetic flux in the rod comprising an element of high permeability material movable across the permanent magnet for varying the magnetic bias flux passing through the rod.

## Patentansprüche

1. Magnetostriktives Stellglied zur Steuerung einer Vorrichtung, mit:
einem zylindrischen Gehäuse, das ein offenes und ein geschlossenes Ende aufweist;
einer in dem Gehäuse gehaltenen Stange aus magneto-striktivem Material, wobei ein festes Ende der Stange an dem geschlossenen Ende des Gehäuses anstößt;
einem in dem Gehäuse angeordneten und mit der Stange magnetisch gekoppelten Elektromagnet; und
einem auf ein extern erzeugtes Bedarfssignal ansprechendes Steuerungssystem zur Erzeugung eines Steuersignals für den Elektromagnet, wobei das Steuersignal und der Elektromagnet ein entsprechendes Magnetfeld innerhalb der Stange induzieren;
gekennzeichnet durch
einen Belastungskopf, der an dem offenen Ende des zylindrischen Gehäuses befestigt ist und das andere, freie Ende der Stange innerhalb einer Axialbohrung aufnimmt, die sich über seine gesamte Länge erstreckt;
ein Verschlußelement, das mit der Axialbohrung in Eingriff steht und einen Hohlraum zwischen dem freien Ende der Stange und dem Verschlußelement begrenzt;

einer in dem Hohlraum angeordneten und zwischen dem Ende der Stange und dem Verschlußelement zusammengedrückten Feder zur Ausübung einer einstellbaren Axialdruckspannung auf das freie Ende der Stange; und ein Betätigungselement, das sich durch das Verschlußelement erstreckt und in Kontakt mit der Stange steht, wobei die Axiallage des Betätigungselements relativ zum Belastungskopf auf die Länge der Stange anspricht und das Betätigungselement mit der zu steuernden Vorrichtung verbindbar ist; wobei die Steuerung umfaßt: eine Auswerteeinheit (2) zur Lieferung von Modellparametern der Reaktion des Steuerungssystems auf eine externe Störung; eine auf die Auswerteeinheit ansprechende Steuereinrichtung (4) zum Vergleich des von der Auswerteeinheit gelieferten Modells mit den gewünschten Parametern und zur Erzeugung von Rückführsignalen als ein Ergebnis eines derartigen Vergleichs; zwei Schaltfilter (5, 6) jeweils zum Anlegen positiver und negativer Rückführsignale an den Steuerstrom; und eine Steuereinheit mit variabler Struktur (8) zur Steuerung der Schaltung zwischen den zwei Filtern in Abhängigkeit von dem Bedarfssignal.

2. Magnetostriktives Stellglied nach Anspruch 1, bei dem das Verschlußelement einstellbar und in die Axialbohrung eingeschraubt ist, wobei die Drehung des Verschlusses zu einer Axialbewegung des Verschlusses, einer Längenänderung des Hohlraumes und einer Veränderung der durch die Feder auf das freie Ende der Stange ausgeübten Axialspannung führt.

3. Magnetostriktives Stellglied nach einem der vorhergehenden Ansprüche, bei dem das Gehäuse einen Vormagnetisierungs-Permanentmagnet aufnimmt, der zusammen mit der Stange einen Magnetkreis umfaßt, wobei das Stellglied ferner eine Einrichtung zur Veränderung des Magnetflusses in der Stange aufweist, mit einem aus einem Material mit hoher Permeabilität bestehenden Element, das zur Veränderung des Vormagnetisierungsflusses durch die Stange über den Permanentmagnet bewegbar ist.

**Revendications**

1. Organe de manoeuvre à magnétostriction destiné à la commande d'un appareil et comprenant un boîtier cylindrique ayant une extrémité ouverte et une extrémité fermée, un barreau d'un matériau magnétostrictif retenu dans le boîtier, une extrémité fixe du barreau étant en butée contre l'extrémité fermée du boîtier, un électro-aimant incorporé au boîtier et couplé magnétiquement au barreau, et un circuit de commande sensible à un signal de demande créé à l'extérieur et destiné à créer lui-même un signal de commande de l'électro-aimant, le signal de commande et l'électro-aimant induisant un champ magnétique correspondant dans le barreau, caractérisé par une tête de charge fixée à l'extrémité ouverte du boîtier cylindrique et logeant l'autre extrémité libre du barreau dans un trou axial sur toute la longueur du boîtier, un organe de fermeture coopérant avec l'intérieur du trou axial et délimitant une cavité entre l'extrémité libre du barreau et l'organe de fermeture, un ressort placé dans la cavité et comprimé entre l'extrémité du barreau et l'organe de fermeture afin qu'il exerce une contrainte axiale ajustable de compression à l'extrémité libre du barreau, et un organe de commande passant dans l'organe de fermeture et placé au contact du barreau, la position axiale du bras de commande par rapport à la tête de charge dépendant de la longueur du barreau, l'organe de commande pouvant être relié à l'appareil commandé, le dispositif de commande comprenant : un circuit d'estimation (2) destiné à donner des paramètres d'un modèle de la réponse du circuit de commande à une perturbation externe, un organe (4) de réalisation de commande, commandé par le circuit d'estimation et destiné à comparer le modèle donné par le circuit d'estimation aux paramètres nécessaires et à créer des signaux de commande par rétroaction à la suite de cette comparaison, deux filtres commutés (5, 6) destinés à l'application des signaux positifs et négatifs de rétroaction de courant de commande respectivement, et un organe (8) de commande à structure variable destiné à commander la commutation entre les deux filtres en fonction du signal de demande.

2. Organe de manoeuvre à magnétostriction selon la revendication 1, dans lequel l'organe de fermeture coopère de façon réglable et par vissage avec le trou axial, la rotation de l'organe de fermeture provoquant un déplacement axial de celui-ci, un changement de longueur de la cavité et un changement de la contrainte axiale appliquée par le ressort à l'extrémité libre du barreau.

3. Organe de manoeuvre à magnétostriction selon l'une quelconque des revendications précédentes, dans lequel le boîtier comprend un aimant permanent de polarisation qui, avec le barreau, forme un circuit de flux magnétique, l'organe de manoeuvre comprenant en outre un dispositif destiné à faire varier le flux magnétique dans le barreau et comprenant un élément d'un matériau de perméabilité élevée mobile par rapport à l'aimant permanent afin qu'il fasse varier le flux magnétique de polarisation passant dans le barreau.

# Fig.1.

# Fig.2.